(19) Europäisches Patentamt

European Patent Office

Office européen des brevets

(11) **EP 0 698 794 A1**

(12) **EUROPÄISCHE PATENTANMELDUNG**

(43) Veröffentlichungstag:
28.02.1996 Patentblatt 1996/09

(51) Int. Cl.$^6$: **G01R 19/165**

(21) Anmeldenummer: 95110933.9

(22) Anmeldetag: 12.07.1995

(84) Benannte Vertragsstaaten:
**DE ES FR GB IT**

(30) Priorität: 24.08.1994 DE 4430049

(71) Anmelder: **SIEMENS AKTIENGESELLSCHAFT**
**D-80333 München (DE)**

(72) Erfinder: **Zitta, Heinz, Dipl.-Ing.**
**A-9580 Drobollach (AT)**

(54) **Schaltungsanordnung zur Unterspannungs-Erkennung**

(57) Schaltungsanordnung zur Unterspannungs-Erkennung einer Spannungsquelle (VBAT) mit einer von der Spannungsquelle (VBAT) gespeisten Referenzspannungsquelle (REF), deren Ausgang (5) den ersten Eingang eines Komparators (2) zugeführt wird, sowie Mitteln (3, 4) zum spannungsteilen deren Ausgangsspannung dem zweiten Eingang des Komparators (2) zugeführt wird und an dessen Ausgang das Detektionssignal abgreifbar ist, wobei die Referenzspannungsquelle (REF) Mittel enthält, die nur dann ein Freigabesignal (6) erzeugen, wenn die Referenzspannung (VREF) einen stabilen Wert erreicht hat, daß der Komparator (2) Schaltmittel (8) enthält, welche vom Freigabesignal (6) angesteuert werden, die den Ausgang (1) des Komparators (2) erst dann freigeben, wenn das Freigabesignal erzeugt wurde.

FIG 1

EP 0 698 794 A1

## Beschreibung

Die Erfindung betrifft eine Schaltungsanordnung zur Unterspannungs-Erkennung nach dem Oberbegriff des Patentanspruchs 1.

Insbesondere bei batteriebetriebenen Geräten stellt eine Schaltungsanordnung zur Unterspannungserkennung eine wichtige Funktion dar. Zur Erkennung einer Unterspannung wird in den meisten Fällen ein Komparator und eine Referenzspannugsquelle verwendet. Jedoch wird die Referenzspannungsquelle zumeist aus der gleichen, nämlich der zu überwachenden Spannungsquelle gespeist.

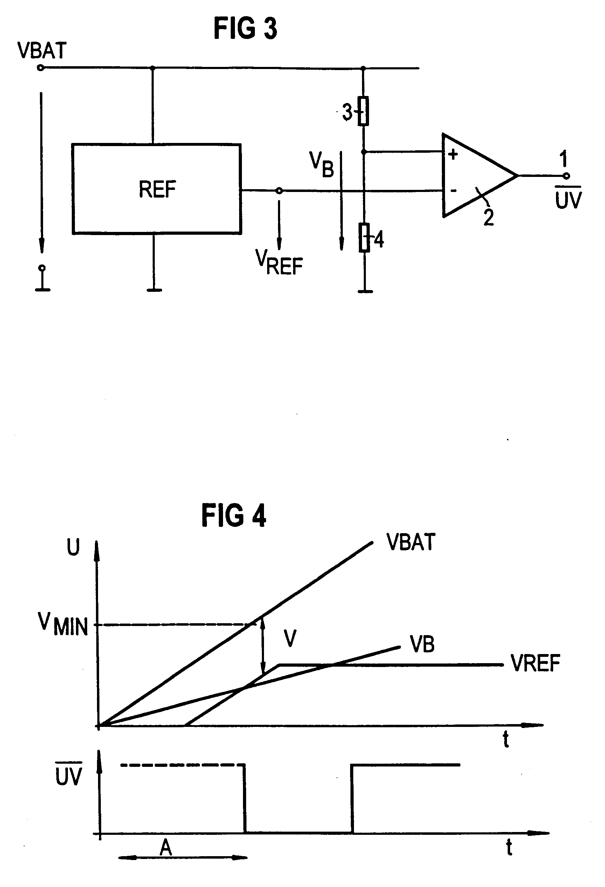

Figur 3 zeigt eine derartige Anordnung. Eine Eingangsklemme, z.B. eine Batterieklemme ist mit VBAT bezeichnet und speist sowohl eine Referenzspannungsquelle REF als auch einen Spannungsteiler 3, 4. Am Knotenpunkt des Spannungsteilers ist die Spannung $V_B$ abgreifbar, die dem positiven Eingang eines Komparators 2 zugeführt wird. Die von der Referenzspannungsquelle REF erzeugte Ausgangsspannung VREF wird dem negativen Eingang des Komparators 2 zugeführt. Eine Ausgangsklemme ist mit 1 bezeichnet, an der die Ausgangsspannung $\overline{UV}$ des Komparators abgreifbar ist.

In der zugehörigen Figur 4 wird der entsprechende Spannungsverlauf dargestellt. Das obere Diagramm zeigt den Verlauf der Eingangsspannung, der Referenzspannung, sowie der Spannung $V_B$ am Spannungsteiler über der Zeit an. Im unteren Diagramm ist der zugehörige Verlauf der Ausgangsspannung $\overline{UV}$ dargestellt.

Durch die Anordnung wird die Spannung VBAT überwacht. Hierzu wird eine durch den Spannungsteiler 3, 4 geteilte $V_B$ mit einer von der Anordnung erzeugten Referenzspannung VREF verglichen. Steigt mit zunehmender Spannung VBAT die entsprechend mitlaufende Spannung $V_B$ über die Referenzspannung VREF an, so schaltet der Ausgang $\overline{UV}$ des Komparators von Low auf High und signalisiert keine Unterspannung.

In der Praxis macht diese Anordnung Probleme, wenn die Referenzspannungsquelle von der gleichen Spannung gespeist wird, wie es in Figur 3 gezeigten Beispiels der Fall ist. In Figur 4 ist der Problembereich mit A gekennzeichnet. Die Spannung VREF ist immer kleiner als die Spannung VBAT, eine Stabilisierung tritt erst bei einem bestimmten Wert von VBAT ein. Schaltungstechnisch bedingt ist ein Mindestoffset $\overline{\Delta V}$ von VBAT zu VREF nicht zu vermeiden. Bei sehr kleiner Spannung VBAT ist die Referenzspannung VREF gleich Null, die Spannung $V_B$ ist jedoch immer proportional VBAT und daher immer größer Null. In einem bestimmten Bereich, der im unteren Diagramm mit A gekennzeichnet ist, ist daher das Signal $\overline{UV}$ logisch falsch und erst ab einer gewissen Eingangsspannung VBAT > VMIN ist die richtige Funktion immer sichergestellt.

Eine andere derartige Überwachungsschaltung ist in der deutschen Offenlegungsschrift DE 34 03 798 gezeigt, in der eine auf die Versorgungsspannung bezogene mittels eines Spannungsteilers erzeugte proportionale Spannung in einem Komparator mit einer Referenzspannung verglichen wird.

In den Dokumenten DE 32 38 544 A1 sowie EP 0 207 159 A1 sind Komparatorschaltungen beschrieben, die Schaltmittel enthalten, mittels derer der Ausgang des Komparators zu Spannungsüberwachung freigegeben werden kann.

In der US-Patentschrift US 3 670 246 ist eine Schaltung zur Spannungsüberwachung beschrieben, bei der eine unerwünschte Signalabgabe beim Einschalten der Spannungsquelle verhindert wird, indem ein Kondensator verwendet wird, durch den ein Schalten der Komparatorstufe definiert verzögert wird.

Aufgabe der vorliegenden Erfindung ist es, eine Schaltungsanordnung zur Unterspannungs-Erkennung anzugeben, deren Schaltschwelle von einer Referenzspannungsschaltung bestimmt wird, und die beim Einschalten der Betriebsspannung sicherer arbeitet.

Diese Aufgabe wird durch den kennzeichnenden Teil des Anspruchs 1 gelöst. Weiterbildungen sind Kennzeichen des Unteranspruchs.

Die Schaltungsanordnung hat den Vorteil, das eine unerwünschte Signalabgabe sicher unterdrückt wird, wenn die Betriebsspannung der gesamten Schaltung zu gering ist, um ein einwandfreies Arbeiten der Referenzspannungsschaltung zu gewährleisten. Insbesondere soll beim Einschalten der Spannungsquelle eine unerwünschte Signalabgabe sicher unterdrückt werden.

Die Erfindung wird nachfolgend anhand von vier Figuren näher erläutert.

Es zeigen:

Figur 1    ein Blockschaltbild der erfindungsgemäßen Anordnung,

Figur 2    ein Ausführungsbeispiel einer erfindungsgemäßen Schaltungsanordnung,

Figur 3    eine Schaltungsanordnung gemäß dem Stand der Technik,

Figur 4    ein Spannungsverlauf, der gemäß dem Stand der Technik aufgebauten Schaltung aus Figur 3.

Die erfindungsgemäße Lösung des zuvor genannten Problems überwacht die Referenzspannungsquelle derart, daß ein eindeutiges Signal generiert wird, wenn diese bei Unterspannung nicht mehr zuverlässig arbeitet. Dieses Steuersignal greift dann in einen Überwachungskomparator ein, der letztlich immer ein logisches richtiges Signal, nämlich Unterspannung bzw. keine Unterspannung ausgibt.

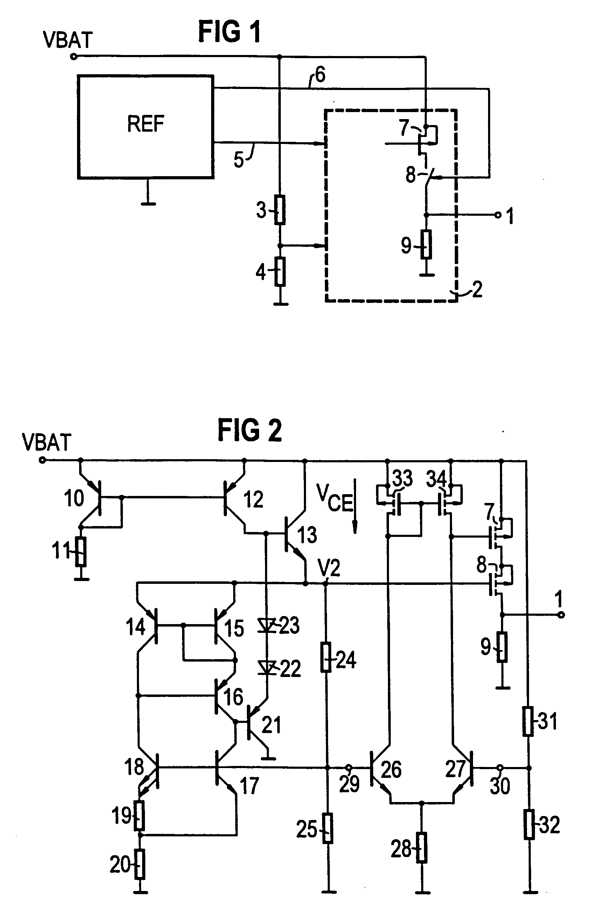

In Figur 1 ist wiederum eine Klemme VBAT dargestellt, die zum einen eine Referenzspannungsquelle REF sowie einen Spannungsteiler 3, 4 speist. Des weiteren speist sie eine Ausgangsschaltung 2. Die Referenzausgangsspannung 5 wird dieser Ausgangsschaltung ebenso zugeführt, wie die am Spannungsteiler 3, 4 abgreifbare Spannung. Die Ausgangsschaltung 2 enthält neben einem Komparator eine schaltbare Ausgangsstufe, welche z.B. einen ersten vom Komparator angesteuerten Schalttransistor 7, sowie in Serie geschaltete Schaltmittel 8 enthält, die über einen Widerstand 9 mit dem Bezugspotential verbunden sind. Am Knotenpunkt des Widerstands 9 mit den Schaltmitteln 8 ist dann die Ausgangsspannungsklemme 1 abgreifbar. Die Referenzspannungsquelle erzeugt ein zweites Signal, welches anzeigt, ob die Referenz bereits in ihrem stabilen Arbeitsbereich arbeitet und steuert mit diesem Signal 6 die Schaltmittel 8.

Jegliche Funktion des Komparators 2, welcher den Ausgangstransistor 7 ansteuert, wird über die Schaltmittel 8 deaktiviert, solange die Referenzspannung nicht ihren stabilen Arbeitsbereich erreicht hat, über den Pull-Down-Widerstand 9 wird das Ausgangssignal an der Klemme 1 auf logisch "Null" gezogen. Auf diese Weise kann sicher gewährleistet werden, daß am Ausgang 1 immer das logisch richtige Signal anliegt, unabhängig von der Höhe der Ausgangsspannung an der Klemme VBAT.

In Figur 2 ist das zugehörige Ausführungsbeispiel einer derartigen Schaltung gemäß Figur 1 dargestellt. Die Klemme VBAT ist über einen als Diode geschalteten pnp-Transistor 10 und einen in Reihe geschalteten Widerstand 11 mit Masse verbunden. Die mit dem Widerstand 11 zusammengeschalteten Basis- und Kollektoranschlüsse des Transistors 10 sind des weiteren mit der Basis eines pnp-Transistors 12 verschaltet. Dessen Emitter ist mit der Klemme VBAT verbunden. Der Kollektor des Transistors 12 ist zum einen mit der Basis eines npn-Transistors 13 sowie mit der Reihenschaltung zweier in Flußrichtung geschalteter Dioden 22, 23 verbunden. Die Reihenschaltung der Dioden 22, 23 ist über die Emitter-Kollektor-Strecke eines pnp-Transistors 21 mit dem Bezugspotential verschaltet. Der Kollektor des Transistors 13 ist mit der Klemme VBAT und der Emitter des Transistors 13 über einen Widerstandsteiler 24, 25 mit dem Bezugspotential verschaltet. Des weiteren ist der Emitter des Transistors 13 jeweils mit den Emittern weiterer pnp-Transistoren 14 und 15 sowie dem Gateanschluß eines MOS-Transistors 8 verbunden. Die Basisanschlüsse der Transistoren 14 und 15 sind miteinander und mit dem Kollektor des Transistors 15 verschaltet. Der Kollektor des Transistors 14 ist mit der Basis eines weiteren pnp-Transistors 16 und dem Kollektor eines weiteren npn-Transistors 18 verbunden. Der Emitter des Transistors 16 ist mit dem Kollektor des Transistors 15 verschaltet und der Kollektor des Transistors 16 ist mit der Basis des Transistors 21 sowie dem Kollektor eines weiteren npn-Transistors 17 verschaltet.

Die Basisanschlüsse der Transistoren 18 und 17 sind miteinander und mit dem Knotenpunkt des Widerstandsteilers 24, 25 gekoppelt. Der Emitter des Transistors 18 ist über einen weiteren Widerstandsteiler 19, 20 mit dem Bezugspotential verbunden. Der Knotenpunkt des Widerstandsteilers 19, 20 ist mit dem Emitter des Transistors 17 verschaltet. Der Knotenpunkt des ersten Widerstandsteilers 24, 25 ist mit einer Klemme 29 verbunden, die mit der Basis eines weiteren npn-Transistors 26 verschaltet ist. Ein weiterer npn-Transistor 27 ist vorgesehen, dessen Emitter mit dem Emitter des Transistors 26 und über einen Widerstand 28 mit dem Bezugspotential verbunden ist. Der Kollektor des Transistors 26 ist mit dem Source- und dem Gateanschluß eines MOS-Transistors 33 verbunden. Der Drainanschluß des MOS-Transistors 33 ist mit der Klemme VBAT verschaltet. Ein weiterer MOS-Transistor 34 ist vorgesehen, dessen Drainanschluß ebenfalls mit der Klemme VBAT und dessen Basis mit Source und Basis des Transistors 33 verbunden ist. Der Sourceanschluß des MOS-Transistors 34 ist mit dem Kollektor des Transistors 27 und dem Basisanschluß eines weiteren MOS-Transistors 7 verbunden. Die Laststrecke der MOS-Transistoren 7 und 8 sind in Reihe zwischen der Klemme VBAT und über einen Widerstand mit dem Bezugspotential verbunden. Zwischen Sourceanschluß des MOS-Transistors 8 und dem Widerstand 9 ist ein Abgriff vorgesehen, der mit der Ausgangsklemme 1 verbunden ist. Schließlich ist ein weiterer dritter Widerstandsteiler 31, 32 vorgesehen, der zwischen der Klemme VBAT und dem Bezugspotential geschaltet ist. Der Mittelabgriff des Teilers 31, 32 ist mit einer Klemme 30 und dem Basisanschluß des Transistors 27 verbunden. Der Knotenpunkt zwischen Emitter des Transistors 13 und dem Widerstandsteiler 24, 25 ist mit V2 bezeichnet.

Die Elemente 14 bis 20 bilden eine Bandgap-Referenzschaltung wie sie vielfach bekannt ist und als Spannungsreferenz verwendet wird. An der Klemme 29 ist dann die Referenzspannung VREF abgreifbar. Diese liegt immer im Bereich von z.B. 1,2 V und über den Widerstandsteiler 24, 25 wird am Knotenpunkt V2 eine interne Betriebsspannungs für die übrige Schaltung festgelegt. Zur sicheren Funktion der Schaltung darf diese Spannung nicht niedriger als z.B. 2,8 V dimensioniert werden. Damit ergibt sich eine minimal erforderliche Betriebsspannung

$$VBAT\ (min) = V2 + VBE\ (13) + VCEsat\ (12),$$

wobei VBE (13) die Basisemitterspannung des Transistors 13 und VCEsat (12) die Kollektor-Emitterspannung am Transistor 12 ist. Diese kann z.B. dann

$$2,8\ V + 0,7\ V + 0,1\ V = 3,6\ V$$

betragen.

Für eine Spannung VBAT < 3,6 V wird also die Referenzspannung VREF nicht den richtigen Wert annehmen. Für jede Spannung höher als 3,6 V bleibt jedoch die Spannung V2 konstant auf 2,8 V, der restliche Spannungsabfall tritt dann an der Kollektor-Emitterstrecke des Transistors 13 auf. Diese Spannung VCE (13) wird als Signal für das Erreichen des stabilen Zustandes der Referenzspannung VREF interpretiert. Erst wenn VCE (13) kleiner als z. B. 0,8 V ist, dann wird der p-Kanaltransistor 8 leitend und gibt den Ausgang des Komparators frei. Dabei wird in diesem Beispiel angenommen, daß die Schwellenspannung des p-Kanal-Transistors 8 immer größer 0,8 V ist.

**Patentansprüche**

1.  Schaltungsanordnung zur Unterspannungs-Erkennung einer Spannungsquelle (VBAT) mit einer von der Spannungsquelle (VBAT) gespeisten Referenzspannungsquelle (REF), deren Ausgang (5) einem ersten Eingang eines Komparators (2) zugeführt wird, sowie mit Mitteln (3, 4) zum Spannungsteilen der von der Spannungsquelle (VBAT) gelieferten Spannung, deren Ausgangsspannung einem zweiten Eingang des Komparators (2) zugeführt wird, wobei an einem Ausgang des Komparators (2) ein Detektionssignal abgreifbar ist,
    **dadurch gekennzeichnet,** daß die Referenzspannungsquelle (REF) Mittel enthält, die nur dann an einem zweiten Ausgang der Referenzspannungsquelle (REF) ein Freigabesignal (6) erzeugen, wenn die Referenzspannung (VREF) einen stabilen Wert erreicht hat, daß der Komparator (2) Schaltmittel (8) enthält, welche vom Freigabesignal (6) angesteuert werden und die den Ausgang (1) des Komparators (2) erst dann freigeben, wenn das Freigabesignal (6) erzeugt wurde.

2.  Schaltungsanordnung nach Anspruch 1,
    **dadurch gekennzeichnet,** daß die Referenzspannungsquelle (REF) eine Bandgap-Schaltungsanordnung (14..20) sowie eine Regelstufe (10..13) enthält, wobei die Regelstufe (10..13) einen Regeltransistor (13) aufweist, dessen Laststrecke während des Regelungsvorgangs einen Spannungsabfall aufweist, sobald die Spannungsquelle (VBAT) einen vorbestimmten Spannungswert überschreitet, und daß dieser Spannungsabfall zum Ansteuern der Schaltmittel (8) des Komparators (2) verwendet wird.

# FIG 1

VBAT

REF

# FIG 3

# FIG 4

Nummer der Anmeldung

EP 95 11 0933

**Europäisches Patentamt**

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | US-A-4 849 656 (NEIDORFF)<br>* Spalte 2, Zeile 56 *<br>--- | 1,2 | G01R19/165 |
| D,A | US-A-3 670 246 (GATELY)<br>* Anspruch 1 *<br>--- | 1 | |
| D,A | EP-A-0 207 159 (FANUC LTD)<br>* Anspruch 1 *<br>--- | 1 | |
| D,A | DE-A-34 03 798 (SHARP)<br>* Anspruch 1 *<br>----- | 1 | |
| | | | **RECHERCHIERTE SACHGEBIETE (Int.Cl.6)**<br><br>G01R |

Der vorliegende Recherchenbericht wurde für alle Patentansprüche erstellt

| Recherchenort | Abschlußdatum der Recherche | Prüfer |
|---|---|---|
| DEN HAAG | 28.November 1995 | Hoornaert, W |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.........................................................................................
& : Mitglied der gleichen Patentfamilie, übereinstimmendes
    Dokument

EPO FORM 1503 03.82 (P04C03)